# FASCICULE DE BREVET EUROPEEN

(11) **EP 1 646 478 B1**
(45) Date de publication et mention de la délivrance du brevet: **07.02.2007**
(21) Numéro de dépôt: 04767750.5
(22) Date de dépôt: 22.07.2004
(51) Int. Cl.: B24B 37/04, H01L 21/304

(54) **PROCEDE DE PREPARATION DE SURFACE EPIREADY SUR FILMS MINCES DE SIC**
VERFAHREN ZUR EPIREADY-OBERFLÄCHEN-BEHANDLUNG AUF SIC-DÜNNSCHICHTEN
METHOD FOR EPIREADY SURFACE TREATMENT ON SIC THIN FILMS

(30) Priorité: 23.07.2003 FR 0308969
(43) Date de publication de la demande: 19.04.2006
(73) Titulaire: S.O.I.TEC. Silicon on Insulator Technologies S.A., 38190 Bernin (FR)
(72) Inventeur: RICHTARCH, Claire, F-38100 Grenoble (FR)
(74) Mandataire: Desormiere, Pierre-Louis
(86) Numéro de dépôt international: PCT/FR2004/001949
(87) Numéro de publication internationale: WO 2005/009684

(56) Documents cités:
- EP-A- 0 966 034
- US-A- 5 895 583
- MALEVILLE C ET AL: "Wafer bonding and H-implantation mechanisms involved in the Smart-cut(R) technology" MATERIALS SCIENCE AND ENGINEERING B, ELSEVIER SEQUOIA, LAUSANNE, CH, vol. 46, no. 1-3, 1 avril 1997 (1997-04-01), pages 14-19, XP004085270 ISSN: 0921-5107
- BRUEL M ET AL: "Smart cut: a promising new SOI material technology" SOI CONFERENCE, 1995. PROCEEDINGS., 1995 IEEE INTERNATIONAL TUCSON, AZ, USA 3-5 OCT. 1995, NEW YORK, NY, USA,IEEE, US, 3 octobre 1995 (1995-10-03), pages 178-179, XP010196531 ISBN: 0-7803-2547-8

## Description

### Domaine technique et art antérieur

La présente invention concerne de manière générale le traitement de matériaux semi-conducteurs destinés à des applications en microélectronique et/ou optoélectronique.

Elle concerne notamment un procédé de préparation de surface d'un film mince, d'épaisseur comprise entre 1 nm ou quelques dizaines de nm et 100 nm ou quelques centaines de nm, par exemple 400 nm ou 500 nm.

En particulier, il s'agit d'un film de carbure de silicium monocristallin, en vue d'y réaliser une croissance d'épitaxie.

Ce peut être un film de carbure de silicium reporté sur un autre matériau (silicium, SiC monocristallin ou polycristallin recouvert d'une couche d'oxyde ou autre : oxyde déposé, nitrure....).

L'invention s'applique notamment à des substrats de SiC, par exemple de polytype 4H, qui sont utilisés pour la croissance épitaxiale, en vue de la fabrication de composants électroniques de puissance.

Pour obtenir une épitaxie de bonne qualité il faut une surface de départ exempte de défauts et la plus lisse possible.

On connaît un procédé de report des couches minces, et notamment des couches minces de SiC, dénommé « Smart-Cut » (ou procédé de fracture de substrat) et décrit par exemple dans l'article de A.J. Auberton-Hervé et al. intitulé « Why can Smart-Cut Change the future of microelectronics ? », Int. Journal of High Speed Electronics and Systems, Vol.10, No1, 2000, p.131-146. Ce procédé laisse une rugosité après fracture de 5 nm RMS environ (RMS = Root Mean Square, ou valeur quadratique moyenne), peu compatible avec une croissance épitaxiale.

Cette rugosité peut être diminuée jusqu'à environ 1 à 2 nm RMS par l'application de traitements de type oxydation thermique (appelé recuit) et/ou gravure ionique. Cependant, ces techniques ne permettent pas d'obtenir une rugosité finale désirée (0.1 à 0.2 nm RMS).

En effet, l'étape de recuit ne consomme pas suffisamment de matériau pour diminuer significativement la rugosité car l'oxydation thermique du SiC est très lente, surtout sur la face silicium.

Par ailleurs, les polissages CMP (mécano-chimiques) du SiC sont difficiles à mettre en oeuvre car les surfaces polies présentent une réactivité chimique faible, comparativement à des matériaux comme le silicium. De plus, le taux d'enlèvement est très faible, de l'ordre de 10 nm par heure, contre 50nm/mn pour le polissage du silicium.

D'autre part, le SiC présente une dureté mécanique extrêmement élevée et l'utilisation d'abrasifs « diamantés » ou de certains abrasifs connus pour le polissage du silicium peuvent conduire à créer des rayures.

Il est donc difficile d'utiliser un abrasif qui permette un taux d'enlèvement suffisant sans créer de telles rayures et des défauts. Les procédés de polissage de SiC sont de ce fait souvent très longs (plusieurs heures) et les abrasifs à base de particules de diamant ne permettent pas d'obtenir une rugosité inférieure à 1 nm RMS.

Les techniques de polissage du SiC sont pour ces deux raisons très particulières. A ce jour, on connaît peu de procédés de polissage de substrat de SiC.

Le document US 5 895 583 décrit un procédé par polissages successifs : en effet, plusieurs étapes sont nécessaires pour éliminer les zones écrouies générées par chaque étape de polissage. Ce procédé utilise des abrasifs à base de particules diamantées de diamètre décroissant.

La demande FR 0 209 869 du 2 août 2002 (FR 2 843 061) décrit un procédé mettant en oeuvre un mélange d'abrasifs (diamant/silice) permettant d'obtenir une rugosité compatible avec un collage par adhésion moléculaire.

Des techniques autres que le polissage existent pour obtenir une faible rugosité : la plupart d'entre elles sont basées sur le bombardement de la surface par des ions issus d'un plasma (RIE) ou d'un faisceau (par exemple, faisceau d'ions d'amas gazeux), technique décrite dans le document US 2002 0014407. Ces techniques sont intéressantes en ce qui concerne les vitesses d'enlèvement mais laissent un état de surface souvent trop rugueux pour une épitaxie et, surtout, elle ne permettent pas d'aplanir la surface.

Il se pose donc le problème de trouver un nouveau procédé de traitement ou de préparation de la surface d'un film, et notamment d'un film de carbure de silicium.

Un autre problème est de trouver un procédé de traitement de films, en particulier de carbure de silicium, permettant d'obtenir une bonne rugosité, et/ou permettant un taux d'enlèvement suffisant sans créer des rayures ou des défauts.

Il se pose aussi un autre problème, qui est de trouver un procédé de traitement de films, en particulier de carbure de silicium, permettant d'obtenir une bonne rugosité, de préférence inférieure à 15 ou 10 Angströms RMS ou à 5 Angströms RMS ou à 1 Angströms RMS, compatible avec une croissance épitaxiale.

### Exposé de l'invention

L'invention concerne un procédé de préparation de surface d'une tranche de carbure de silicium selon la revendication 1.

La combinaison de ces deux étapes permet de réaliser un état de surface satisfaisant, du carbure de silicium.

L'étape de recuit permet d'obtenir une rugosité inférieure à ou de l'ordre de 20 Å RMS. Elle peut être effectuée à température comprise entre 1100°C et 1300°C, et, par exemple, pendant une durée comprise entre 1,5 h et 2,5 h.

Après l'étape de recuit, une étape de désoxydation de la surface peut être réalisée, par exemple du type mettant en oeuvre un bain chimique tel que de l'acide fluohydrique. Dans le cas d'une gravure ionique, une étape de nettoyage chimique type RCA (SC1, SC2) peut être réalisée après l'étape de recuit.

Le polissage est par exemple effectué avec une silice colloïdale de type SYTON W30, et avec une tête de polissage tournant à une vitesse comprise entre 10 et 100 tours/minute.

Une étape de nettoyage chimique peut être prévue après polissage, par exemple mettant en oeuvre un bain d'acide fluorhydrique.

Enfin, une étape de gravure ionique peut aussi être prévue par exemple avant l'étape de recuit.

### Brève description des figures

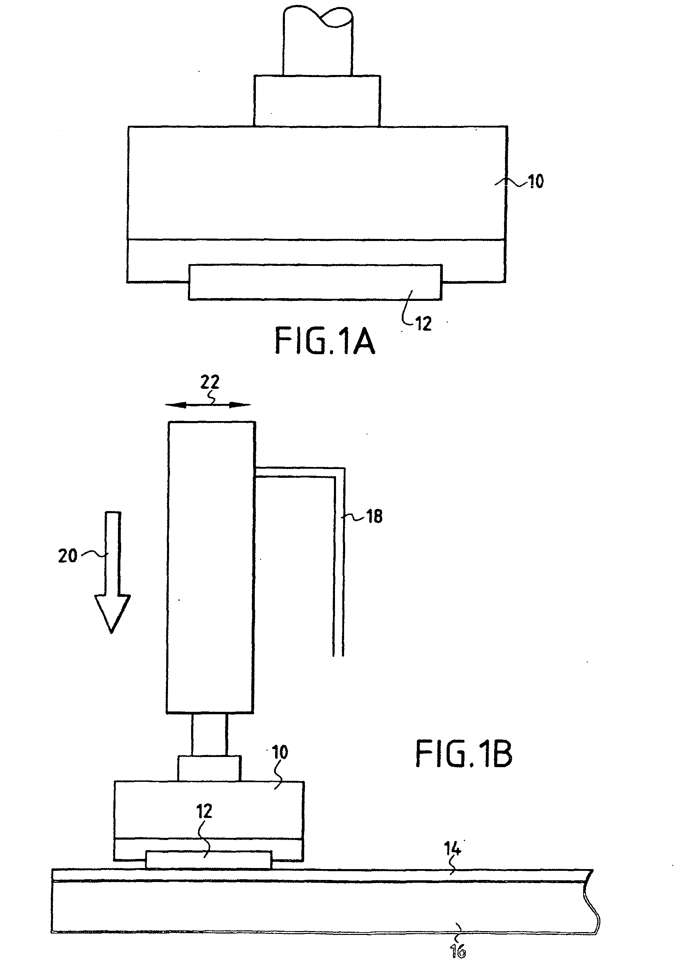

- les figures 1A et 1B représentent schématiquement une installation de polissage.

### Description détaillée des modes de réalisation de l'invention

Un exemple de réalisation va être donné, qui concerne la face silicium d'un film de SiC. On rappelle que le SiC est un matériau polaire, il comporte donc deux faces constituées d'atomes différents (une face silicium et une face carbone).

Un tel film mince est par exemple obtenu par le procédé de fracture de substrat (ou « Smart-Cut »), tel que décrit dans l'article de A.J. Auberton-Hervé et al. cité ci-dessus.

Est d'abord réalisé un traitement thermique sous atmosphère oxydante de ce film mince, par exemple à température comprise entre 1100°C ou 1150°C et 1300°C et pendant une durée comprise entre 1h et 3 h. Cette étape de recuit sous atmosphère oxydante permet d'obtenir une rugosité de l'ordre de 2 nm RMS. Un exemple de dispositif permettant de réaliser un tel recuit est décrit dans Thermal and Dopant Processes, Chapitre 4, Advanced Semiconductor Fabrication Handbook, ICE, 1998.

Une gravure chimique, par exemple à l'acide fluorhydrique à 10%, permet de désoxyder la surface ainsi traitée.

Puis on procède à un polissage CMP (polissage mécano chimique), par exemple avec un tissu IC1000 (distribué par la société RODEL', compressibilité = 3%) et un abrasif à base de particules de silice colloïdale de type SYTON W30 (ou LuDox) (de pH = 10,2, de viscosité = 2 mPs.sec, de taille moyenne des particules = 125 nm et contenant 30% en poids de SiO2).

Une tête de polissage 10, dans laquelle est insérée un substrat 12 à polir, est représentée sur la figure 1A. La figure 1B représente la tête de polissage, le substrat 12 à polir, ainsi qu'un plateau 16 et un tissu 14 de polissage. Un liquide abrasif est injecté dans la tête, par exemple par un conduit latéral 18. Une pression 20 et un mouvement symbolisé par la flèche 22 sont appliqués à la tête 10 pour effectuer le polissage.

Eventuellement, un nettoyage chimique à l'acide fluorhydrique permet d'éviter la cristallisation de l'abrasif en surface.

Un tel procédé permet d'obtenir une surface dont la rugosité permet une reprise d'homoépitaxie (épitaxie de SiC sur SiC) de bonne qualité et éventuellement aussi une reprise d'hétéroépitaxie (AlN, AlGaN ou GaN sur SiC).

Selon un exemple qui concerne un film mince de SiC de type 4H (obtenu par « Smart-Cut ») :
- on réalise une étape de recuit sous atmosphère oxydante (2h à 1150°C par exemple), suivi d'une désoxydation de la surface dans un bain de HF à 10%,
- puis un polissage de la surface par CMP. Ce polissage est effectué dans les conditions suivantes :
   * utilisation d'un plateau de polissage rotatif sur lequel est appliquée une tête de polissage également rotative, les rotations étant de l'ordre de 60tr/mn (cette vitesse peut aussi être comprise entre 10 et 100tr/mn) ; une pression de 0,75 bar (pouvant aussi être comprise entre 0.1 et 1 bar) est appliquée à la tête,
   * le tissu utilisé est un tissu « dur », type IC1000, distribué par RODEL, avec un slurry qui est de la silice colloïdale de type SYTON W30.

La durée du polissage est de 15 mn à 30 mn.

La rugosité obtenue après polissage est de l'ordre de 3 Å RMS.

Un nettoyage final est réalisé, à l'eau désionisée et avec un bain de HF à 10%, pendant 10 mn.

Le tableau I ci-dessous résume des résultats obtenus sur des films minces de SiC dans différentes conditions.

**Tableau I**

| **I** | **II** | **III** | **IV** | **V (nm)** | **VI** |
|---|---|---|---|---|---|
| **1** | Aucun | | | 5,02 | |
| **2** | gravure ionique +recuit 1150°C, durée: 2h | | | 3,02 | |
| **3** | gravure ionique +recuit 1150°C, durée: 2h | 30mn/70tr/mn/0,75b | UR 100/glansox | 0,583 | tissu mou |
| **4** | recuit 1150°C, durée: 2h | 30mn/60tr/mn/0,75b | UR 100/glansox | 1,246 | tissu mou |
| **5** | recuit 1150°C, durée: 2h + Gravure ionique | | | 1,12 | |
| **6** | recuit 1150°C, durée: 2h | | | 2,54 | importance du recuit pour diminuer la rugosité |
| **7** | recuit 1300°C, durée: 1h | | | 1,64 | |
| **8** | recuit 1150°C, durée: 2h | 15mn/25tr/mn/0,6b | IC1000/syton | 0,267 | vitesse de rotation assez lente |
| **9** | recuit 1150°C, durée: 2h | 30mn/60tr/mn/0,75b | IC1000/syton | 0,101 | |
| **10** | recuit 1150°C, durée: 2h | 15mn/60tr/mn/0,75b | IC1000/syton | 0,155 | tissu périmé |
| **11** | recuit 1150°C, durée: 2h | 15mn/60tr/mn/0,75b | IC1000/syton | 0,064 | tissu neuf |

Dans ce tableau, la colonne I indique le numéro d'essai, et la colonne II donne la nature du traitement effectué avant polissage CMP. Pour les essais 2 et 3, il s'agit d'une gravure ionique suivi d'un recuit à 1150°C pendant deux heures, pour l'essai n° 5 d'un recuit à 1150°C pendant deux heures, suivi d'une gravure ionique.

Pour les essais 4, 6 et 8 à 10, seul un recuit à 1150°C, pendant deux heures est réalisé.

La colonne III indique les conditions de réalisation du polissage CMP : durée, vitesse de rotation, pression appliquée.

Dans la colonne IV sont indiquées la nature du tissu (ou « pad ») et du mélange abrasif.

La colonne V donne les mesures de rugosité, sur une surface de 5 x 5 µm2.

Des remarques sont éventuellement consignées dans la colonne VI.

Ce tableau montre bien que la combinaison d'une étape de recuit, puis d'un polissage, permet d'améliorer sensiblement la rugosité du film initial, à moins de 2 nm RMS (essais 3-5 et 7 - 11), 1,5 (essais 3-5, 8 -11) ou 1 nm RMS (essais 3, 8 -11), ou de 0,5 nm RMS (essais 8-11), ou de 0,1 nm RMS (essai 11).

L'invention permet donc d'obtenir un film de carbure de silicium, de rugosité inférieure à 2 nm RMS ou à 1 nm RMS ou à 0,5 nm RMS ou à 0,1 nm RMS.

L'utilisation, comme dans l'essai n°3, d'une gravure ionique préalable améliore également ce résultat.

Les meilleurs résultats paraissent obtenus avec un tissu de type IC1000 et avec une solution abrasive de type Syton W30.

Le tableau II donne des conditions plus détaillées concernant les essais n° 10 et 11.

L'essai n° 10 est réalisé sur une plaque dénommée « S107 », tandis que l'essai n° 11 est réalisé sur la plaque « S126 ».

Le tableau II donne des rugosités comparées des plaques S126 et S107.

Deux types de mesures ont été effectuées : la mesure avec un balayage sur une certaine surface (colonne S, surface indiquée en µm²), et des mesures effectuées ponctuellement (colonne B, surfaces de mesure indiquées en µm x µm).

Dans les trois dernières colonnes sont successivement indiquées, en Angströms: la rugosité en valeur quadratique moyenne (RMS), la rugosité moyenne (Ra), et la rugosité maximale (Rmax).

Les valeurs rapportées dans le tableau I, pour les essais 10 et 11 correspondent respectivement à celles indiquées dans les troisième et septième lignes du tableau II (colonne RMS).

**Tableau II**

| **Rugosités comparées des plaques S126 et S107** | | | | | |
|---|---|---|---|---|---|
| Plaque | S (µm²) | B µm | RMS (Å) | Ra (Å) | Rmax (Å) |
| S107 | 1µm x 1µm | | 0,97 | 0,77 | 14,7 |
| | | 0,3 x 0,9 | 0,7 | 0,55 | 8,2 |
| | 5µm x 5µm | | 1,55 | 1,21 | 16,1 |
| | | 3 x 1 | 1,38 | 1,06 | 12,1 |
| S126 | 1µm x 1µm | | 0,37 | 0,28 | 7 |
| | | 0,6 x 0,7 | 0,34 | 0,27 | 3 |
| | 5µm x 5µm | | 0,64 | 0,5 | 29,7 |
| | | 1,5 x 4 | 0,31 | 0,25 | 4,9 |

Les résultats de ces tableaux montrent que l'invention permet d'obtenir une surface prête à l'épitaxie (surface dite « epiready ») sur des films minces de SiC, par une technique rapide, qui met en oeuvre des étapes et des machines standards en microélectronique. Plus la surface du SiC est lisse et non rugueuse, plus l'épitaxie sera de bonne qualité, permettant d'augmenter sensiblement le rendement des composants électroniques réalisés sur le film mince.

Ce procédé de préparation de surface de l'invention, comprenant une étape de recuit puis de polissage, permet donc d'obtenir une surface de bonne qualité, non rugueuse et applanie.

L'exemple d'un substrat SiC de polytype 4 H a été donné, mais l'invention peut aussi s'appliquer à un substrat SiC de polytype 6H ou 3C.

## Revendications

1. Procédé de préparation d'une surface d'une tranche de matériau, mettant en oeuvre :
- une étape de recuit sous atmosphère oxydante, pour réduire la rugosité à la surface de la tranche,
- suivie d'une étape de polissage avec un abrasif à base de particules de silice colloïdale.

2. Procédé selon la revendication 1, l'étape de recuit étant effectuée à température comprise entre 1000°C et 1300°C.

3. Procédé selon la revendication 1 ou 2, l'étape de recuit étant effectuée pendant une durée comprise entre 1 h et 2,5 h.

4. Procédé selon l'une des revendications précédentes, comportant en outre une étape de gravure ionique.

5. Procédé selon l'une des revendications 1 à 3, comportant en outre, après l'étape de recuit, une étape de désoxydation de la surface.

6. Procédé selon la revendication 4, comportant en outre, après l'étape de recuit, une étape de nettoyage chimique type RCA (SC1, SC2) dans le cas d'une gravure ionique.

7. Procédé selon la revendication 5, l'étape de désoxydation mettant en oeuvre un bain chimique d'acide fluohydrique.

8. Procédé selon l'une des revendications 1 à 7, mettant en oeuvre, après polissage, une étape de nettoyage chimique.

9. Procédé selon la revendication 8, l'étape de nettoyage mettant en oeuvre un bain d'acide fluorhydrique.

10. Procédé selon l'une des revendications précédentes, le polissage étant effectué avec une tête de polissage tournant à une vitesse comprise entre 10 et 100 tours/minute.

11. Procédé selon la revendication 10, une pression comprise entre 0,1 bar et 1 bar étant appliquée à la tête de polissage.

12. Procédé selon l'une des revendications précédentes, le polissage étant effectué pendant une durée comprise entre 15 mn et 30 mn.

## Claims

1. A method of preparing the surface of a wafer of material, the method employing:
- a step of annealing in an oxidizing atmosphere in order to reduce the roughness at the surface of the wafer,
- followed by a step of polishing with an abrasive based on particles of colloidal silica.

2. A method according to claim 1, in which the annealing step is carried out at a temperature in the range 1000°C to 1300°C.

3. A method according to claim 1 or claim 2, in which the annealing step is carried out for a period in the range 1 h to 2.5 h.

4. A method according to one of the preceding claims, further comprising an ion etching step.

5. A method according to one of claims 1 to 3, further comprising, after the annealing step, a step of deoxidation of the surface.

6. A method according to claim 4, further comprising, after the annealing step, an RCA (SC1, SC2) type chemical cleaning step in the case of ion etching.

7. A method according to claim 5, in which the deoxidation step employs a chemical bath of hydrofluoric acid.

8. A method according to one of claims 1 to 7, in which after polishing, a chemical cleaning step is carried out.

9. A method according to claim 8, in which the cleaning step employs a bath of hydrofluoric acid.

10. A method according to one of the preceding claims, in which polishing is carried out with a polishing head rotating at a rate in the range 10 rpm to 100 rpm.

11. A method according to claim 10, in which a pressure in the range 0.1 bar to 1 bar is applied to the polishing head.

12. A method according to one of the preceding claims, in which polishing is carried out for a period in the range 15 minutes to 30 minutes.

## Patentansprüche

1. Verfahren zum Präparieren einer Oberfläche eines Werkstoff-Wafers, bei dem folgendes durchgeführt wird:
- ein Glühschritt unter oxidierender Atmosphäre, um die Rauhigkeit an der Oberfläche des Wafers zu verringern,
- an den sich ein Polierschritt mit einem Schleifmittel auf der Basis von Partikeln aus kolloidalem Siliziumdioxid anschließt.

2. Verfahren nach Anspruch 1, wobei der Glühschritt bei einer Temperatur zwischen 1000°C und 1300°C durchgeführt wird.

3. Verfahren nach Anspruch 1 oder 2, wobei der Glühschritt über eine Zeitdauer von 1 Stunde bis 2,5 Stunden durchgeführt wird.

4. Verfahren nach einem der vorhergehenden Ansprüche, das weiterhin einen lonenätz-Schritt umfaßt.

5. Verfahren nach einem der Ansprüche 1 bis 3, das ferner - im Anschluß an den Glühschritt - einen Schritt zum Desoxidieren der Oberfläche umfaßt.

6. Verfahren nach Anspruch 4, welches ferner im Falle eines lonenätzens - im Anschluß an den Glühschritt - einen Schritt zur chemischen Reinigung vom Typ RCA (SC1, SC2) umfaßt.

7. Verfahren nach Anspruch 5, wobei bei dem Schritt des Desoxidierens ein chemisches Bad aus Fluorwasserstoffsäure eingesetzt wird.

8. Verfahren nach einem der Ansprüche 1 bis 7, bei dem im Anschluß an das Polieren ein Schritt zur chemischen Reinigung durchgeführt wird.

9. Verfahren nach Anspruch 8, wobei bei dem Reinigungsschritt ein Bad aus Fluorwasserstoffsäure eingesetzt wird.

10. Verfahren nach einem der vorhergehenden Ansprüche, wobei das Polieren mit einem sich mit einer Geschwindigkeit von 10 bis 100 Umdrehungen/Minute drehenden Polierkopf durchgeführt wird.

11. Verfahren nach Anspruch 10, wobei ein Druck zwischen 0,1 bar und 1 bar an den Polierkopf angelegt wird.

12. Verfahren nach einem der vorhergehenden Ansprüche, wobei das Polieren über eine Zeitdauer von 15 Min. bis 30 Min. vollzogen wird.
